(19) Europäisches Patentamt
European Patent Office
Office européen des brevets

(11) **EP 1 198 877 B1**

(12) **EUROPÄISCHE PATENTSCHRIFT**

(45) Veröffentlichungstag und Bekanntmachung des Hinweises auf die Patenterteilung:
**16.06.2004 Patentblatt 2004/25**

(51) Int Cl.⁷: **H02M 7/48**

(21) Anmeldenummer: 00920693.9

(86) Internationale Anmeldenummer:
**PCT/EP2000/003275**

(22) Anmeldetag: **12.04.2000**

(87) Internationale Veröffentlichungsnummer:
**WO 2001/010007 (08.02.2001 Gazette 2001/06)**

(54) **ELEKTRISCHE SCHALTUNG, INSBESONDERE FÜR EINEN MITTELSPANNUNGSSTROMRICHTER**

ELECTRIC CIRCUIT, IN PARTICULAR FOR A MEDIUM-VOLTAGE POWER CONVERTER

MONTAGE ELECTRIQUE DESTINE EN PARTICULIER A UN CONVERTISSEUR A TENSION MOYENNE

(84) Benannte Vertragsstaaten:
**DE FI FR GB IT**

(30) Priorität: **31.07.1999 DE 19936117**
**20.12.1999 DE 19961382**

(43) Veröffentlichungstag der Anmeldung:
**24.04.2002 Patentblatt 2002/17**

(73) Patentinhaber: **ALSTOM Power Conversion GmbH**
**12277 Berlin (DE)**

(72) Erfinder:
• **SALAMA, Samir**
**D-13591 Berlin (DE)**
• **JAKOB, Roland**
**D-12524 Berlin (DE)**
• **BEINHOLD, Georg**
**D-13467 Berlin (DE)**

(74) Vertreter: **Schäfer, Wolfgang, Dipl.-Ing.**
**Dreiss, Fuhlendorf, Steimle & Becker**
**Postfach 10 37 62**
**70032 Stuttgart (DE)**

(56) Entgegenhaltungen:
**EP-A- 0 533 158     EP-A- 0 913 918**
**EP-A- 0 977 348     WO-A-99/40676**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft eine elektrische Schaltung, insbesondere für einen Mittelspannungsstromrichter, mit mindestens vier Halbleiterschaltern, die eine aus zwei Teilen bestehende Reihenschaltung bilden, die mit Polen einer Gleichspannung verbunden ist, wobei jedem der Halbleiterschalter eine Diode gegensinnig parallelgeschaltet ist, und wobei zu den Halbleiterschaltern ein Kondensator parallelgeschaltet ist, mit einem Pol einer Ausgangsspannung, der mittig mit der Reihenschaltung verbunden ist, und der die beiden Teile der Reihenschaltung voneinander trennt, und mit einem Steuergerät zur aufeinanderfolgenden Ansteuerung der Halbleiterschalter der beiden Teile der Reihenschaltung.

Eine derartige elektrische Schaltung ist aus der WO 99/40676 (Dokument nach Art. 54 Abs. 3 EPÜ) bekannt und wird insbesondere bei Mittelspannungsstromrichtern eingesetzt. Die Gleichspannung ist mit den äußeren beiden Abgriffen der eine Reihenschaltung bildenden Halbleiterschalter verbunden und an deren gemeinsamen, mittleren Abgriff liegt die Ausgangsspannung an. Die Halbleiterschalter werden von einem Steuergerät nacheinander in ihren leitenden und ihren sperrenden Zustand geschaltet. Die entstehende Wechselspannung besteht aus einer Abfolge von Pulsen.

Aufgrund von immer vorhandenen Unterschieden der Betriebsgrößen der in Reihe geschalteten Halbleiterschalter kann es zu unsymmetrischen Spannungsaufteilungen auf die verschiedenen Halbleiterschalter kommen, was zu Überbeanspruchungen einzelner Halbleiterschalter führen kann. Ebenfalls hat die Umschaltung der Halbleiterschalter zur Folge, dass der Spannungssprung der einzelnen Pulse der Ausgangsspannung sehr groß ist, was zu Überspannungsspitzen führen kann. Diese Nachteile werden bei bekannten Stromrichtern mit erheblichem schaltungstechnischen Aufwand ausgeräumt oder zumindest gemindert.

Aufgabe der Erfindung ist es, eine elektrische Schaltung und ein Verfahren der eingangs genannten Art zu schaffen, die geringe Überspannungsspitzen erzeugen, ohne dass hierzu ein besonderer Aufwand erforderlich ist.

Diese Aufgabe wird bei einer elektrischen Schaltung der eingangs genannten Art erfindungsgemäß dadurch gelöst, dass der Kondensator nur zu den beiden mittleren Halbleiterschaltern parallelgeschaltet ist, und dass der zeitliche Abstand zwischen den Übergängen zweier Halbleiterschalter desselben Teils der Reihenschaltung in den jeweils leitenden Zustand zwischen etwa 0,01 Mikrosekunden und etwa 10 Mikrosekunden, vorzugsweise etwa 2 Mikrosekunden beträgt.

Mit Hilfe der erfindungsgemäßen Schaltung ist es möglich, die einzelnen Pulse der Ausgangsspannung stufenförmig auszubilden. Es entsteht also ein stufenförmiger Verlauf insbesondere der Flanken der Ausgangsspannung. Dies bedeutet gleichzeitig, dass nur ein Teil der gesamten Gleichspannung in ein- und demselben Zeitpunkt bei der Ausgangsspannung geschaltet wird. Die Spannungssprünge der einzelnen Stufen der Ausgangsspannung sind damit kleiner als bei der bekannten Schaltung. Dies führt zu kleineren Überspannungsspitzen und Spannungssteilheiten bei der Ausgangsspannung.

Der für die Erfindung erforderliche schaltungstechnische Aufwand beschränkt sich im Wesentlichen im Vergleich zum Stand der Technik auf eine unterschiedliche Ansteuerung der Halbleiterschalter.

Weiterhin wird der zeitliche Abstand zweier aufeinanderfolgender Stufen der Ausgangsspannung festgelegt. Ein derartiger kleiner zeitlicher Abstand zwischen den erfindungsgemäßen Stufen bringt den wesentlichen Vorteil mit sich, dass aufgrund des kurzen zeitlichen Abstands die Kondensatoren, über die während dieses Abstands ein Strom fließt, nur geringfügig belastet werden. Es ist damit nicht erforderlich, große Kondensatoren vorzusehen, so dass der schaltungstechnische Aufwand diesbezüglich gering bleibt und im Vergleich zum Stand der Technik sogar vermindert werden kann.

Bei einer vorteilhaften Ausgestaltung der Erfindung ist der zeitliche Abstand zwischen den Übergängen zweier Halbleiterschalter in Abhängigkeit von der Schaltzeit eines der Halbleiterschalter und/oder der Resonanzfrequenz der Last, gegebenenfalls einschließlich der vorhandenen Kabel gewählt. Damit wird eine Reduktion der resultierenden Spannungsanstiegsgeschwindigkeit sowie der Überspannungsspitzen an der Last erreicht.

Bei einer vorteilhaften Weiterbildung der Erfindung sind entsprechende weitere Halbleiterschalter, Dioden und Kondensatoren vorgesehen, wobei die Halbleiterschalter der Reihenschaltung durch das Steuergerät nacheinander in den leitenden Zustand steuerbar sind. Damit können die einzelnen Pulse der Ausgangsspannung beliebig feinstufig ausgebildet werden. Gleichzeitig werden Überspannungsspitzen aufgrund der immer kleiner werdenden Spannungssprünge weiter reduziert.

Besonders vorteilhaft ist es, wenn die Kapazität des Kondensators bzw. der Kondensatoren sehr klein ist. Wie bereits erwähnt, wird damit der Aufwand für die Realisierung der erfindungsgemäßen feinstufigen Ausgangsspannung weiter reduziert.

Bei einer vorteilhaften Ausgestaltung der Erfindung ist der zeitliche Abstand zwischen den Übergängen zweier benachbarter Halbleiterschalter in den jeweils leitenden Zustand groß, insbesondere zwischen etwa 100 Mikrosekunden und etwa 500 Mikrosekunden, vorzugsweise etwa 250 Mikrosekunden.

Durch diesen großen zeitlichen Abstand wird - bildlich gesehen - ein Absatz in der stufenförmigen Ausgangsspannung erzeugt. Dieser Absatz bringt den Vorteil mit sich, dass Stromoberschwingungen, die an sich bei den üblichen Schaltfrequenzen der Halbleiterschalter von etwa 500 Hz bis etwa 1000 Hz entstehen würden, stark gedämpft werden bzw. in geringerem Umfang entstehen. Die genannten verminderten Stromoberschwingungen werden dabei im Wesentlichen nur durch die entsprechende Ansteuerung der Halbleiterschalter erreicht, so dass insoweit kein besonderer schaltungstechnischer Aufwand erforderlich ist.

Die Erfindung besteht auch in einem entsprechenden Verfahren zum Betreiben einer elektrischen Schaltung, insbesondere für einen Mittelspannungsstromrichter.

Mit dem vorgenannten erfindungsgemäßen Verfahren wird der bereits beschriebene stufenförmige Verlauf der Ausgangsspannung erzeugt. Wie ebenfalls bereits erwähnt, ist hierzu im Wesentlichen nur eine entsprechende Ansteuerung der Halbleiterschalter erforderlich, wobei in Abhängigkeit von den zeitlichen Abständen dieser Ansteuerungen entweder kurz aufeinanderfolgende Stufen oder länger beabstandete Absätze erzeugt werden können.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.

Figur 1    zeigt einen schematischen Schaltplan eines ersten Ausführungsbeispiels einer erfindungsgemäßen elektrischen Schaltung,

Figur 2    zeigt ein schematisches Zeitdiagramm der Ausgangsspannung der Schaltung der Figur 1,

Figur 3    zeigt einen schematischen Schaltplan eines zweiten Ausführungsbeispiels einer erfindungsgemäßen elektrischen Schaltung,

Figur 4    zeigt einen schematischen Schaltplan eines dritten Ausführungsbeispiels einer erfindungsgemäßen elektrischen Schaltung,

Figur 5    zeigt ein schematisches Zeitdiagramm der Ausgangsspannung der Schaltung der Figur 3, und

Figur 6    zeigt ein schematisches Zeitdiagramm der Ausgangsspannung der Schaltung der Figur 4.

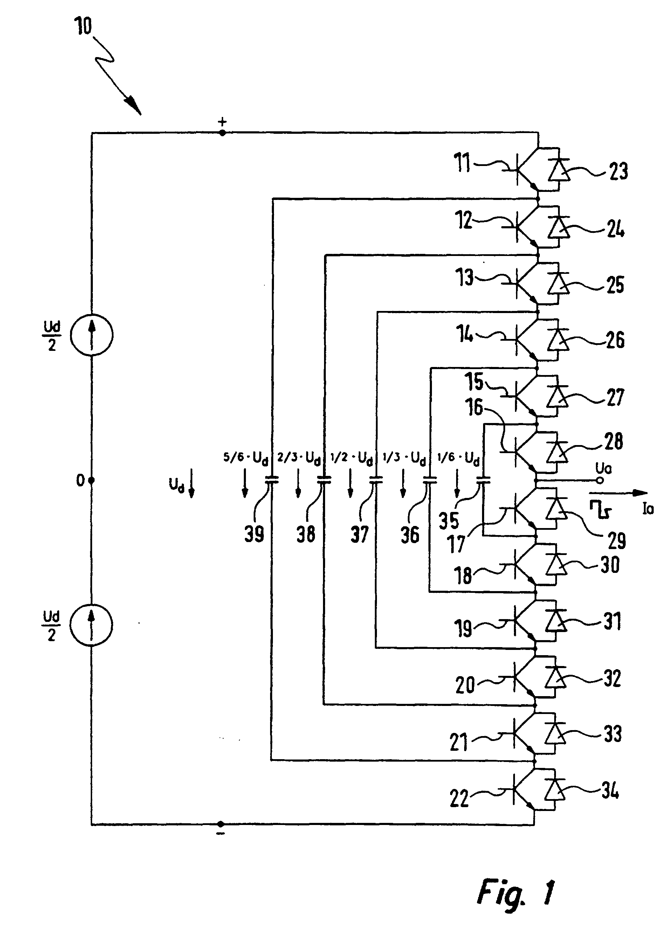

In der Figur 1 ist eine elektrische Schaltung 10 dargestellt, die insbesondere bei einem Mittelspannungsstromrichter anwendbar ist, mit dem beispielsweise ein Elektromotor als Last gespeist wird.

Die Schaltung 10 ist eingangsseitig mit einer Gleichspannung Ud beaufschlagt, die entsprechend den Angaben in der Figur 1 gepolt ist. Die Gleichspannung Ud kann in einem Bereich von etwa 1 kV bis etwa 100 kV, vorzugsweise bei etwa 16 kV liegen. Von der Schaltung 10 wird die Gleichspannung Ud in eine Wechselspannung Ua umgeformt, die aus einer Abfolge von Pulsen besteht.

Üblicherweise sind in einem Mittelspannungsstromrichter drei derartige Schaltungen 10 vorhanden, mit denen jeweils eine Phase einer dreiphasigen Wechselspannung erzeugt wird.

In der Schaltung 10 sind zwischen dem Plus- und dem Minuspol der Gleichspannung Ud zwölf Halbleiterschalter 11 bis 22 in Reihe geschaltet. Die Ansteuerung der Halbleiterschalter 11 bis 22 wird von einem in der Figur 1 nicht dargestellten Steuergerät durchgeführt.

Jedem der Halbleiterschalter 11 bis 22 ist eine Diode 23 bis 34 gegensinnig parallelgeschaltet.

Parallel zu den beiden Halbleiterschaltern 16, 17 mit den zugehörigen Dioden 28, 29 ist ein Kondensator 35 geschaltet. Parallel zu den vier Halbleiterschaltern 15 bis 18 mit den zugehörigen Dioden 27 bis 30 ist ein Kondensator 36 geschaltet. Parallel zu den sechs Halbleiterschaltern 14 bis 19 mit den zugehörigen Dioden 26 bis 31 ist ein Kondensator 37 geschaltet. Parallel zu den acht Halbleiterschaltern 13 bis 20 mit den zugehörigen Dioden 25 bis 32 ist ein Kondensator 38 geschaltet. Und schließlich ist parallel zu den zehn Halbleiterschaltern 12 bis 21 mit den zugehörigen Dioden 24 bis 33 ein Kondensator 39 geschaltet.

Es wird davon ausgegangen, dass die Kondensatoren 35 bis 39, wie in der Figur 1 angegeben, auf folgende Spannungen aufgeladen sind: der Kondensator 35 ist auf 1/6 der Gleichspannung Ud aufgeladen, der Kondensator 36 ist auf 1/3 der Gleichspannung Ud aufgeladen, der Kondensator 37 ist auf 1/2 der Gleichspannung Ud aufgeladen, der Kondensator 38 ist auf 2/3 der Gleichspannung Ud aufgeladen, und der Kondensator 39 ist schließlich auf 5/6 der Gleichspannung Ud aufgeladen. Diese Aufladung der Kondensatoren 35 bis 39 kann durch entsprechende schaltungstechnische Maßnahmen erreicht werden.

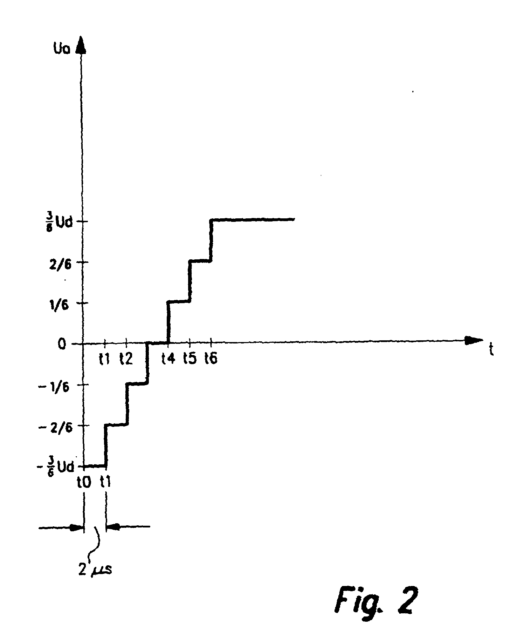

In der Figur 2 ist ein Zeitdiagramm eines Pulses der Wechselspannung Ua über der Zeit t dargestellt. Es wird davon ausgegangen, dass in einem Zeitpunkt t0 alle Halbleiterschalter 11 bis 16 gesperrt und alle Halbleiterschalter 17 bis 22 leitend sind. Weiter wird davon ausgegangen, dass die Ausgangsspannung Ua im Zeitpunkt t0 gleich -3/6 Ud ist und ein Ausgangsstrom Ia über die Dioden 29 bis 34 zur Last fließt. Ebenfalls wird davon ausgegangen, daß immer komplementäre Halbleiterschalter geschaltet werden, also z.B. der Halbleiterschalter 11 gesperrt und dann der Halbleiterschalter 22 leitend geschaltet wird, oder der Halbleiterschalter 11 leitend geschaltet und dann der Halbleiterschalter 22 gesperrt wird.

Wenn im Zeitpunkt t1 z.B. der Halbleiterschalter 11 leitend gesteuert und der Halbleiterschalter 22 gesperrt wird und die Halbleiterschalter 12 bis 16 gesperrt sowie die Halbleiterschalter 17 bis 21 leitend bleiben, fließt ein Strom von dem Pluspol der Gleichspannung Ud über den Halbleiterschalter 11, über den Kondensator 39 und über die Dioden 33, 32, 31, 30 und 29 zu dem Pol der Ausgangsspannung Ua.

Es ist sinnvoll mit der Ansteuerung des Halbleiterschalters 11 zu beginnen, wenn der Kondensator 39 eine Spannung kleiner als 5/6 Ud aufweist und die Abweichung betragsmäßig die größte von allen Kondensatoren ist, da mit dem Einschalten des Halbleiterschalters 11 dieser Kondensator 39 aufgeladen wird. In dieser Art und Weise lässt sich über die Reihenfolge der Ansteuerung der Halbleiterschalter und über den Zeitverzug die Symmetrie der Kondensatorspannungen steuern.

Aufgrund des auf 5/6 der Gleichspannung Ud aufgeladenen Kondensators 39 verbleiben von der Gleichspannung -3/6 Ud nur noch -2/6 Ud derselben als Ausgangsspannung Ua in diesem Zeitpunkt t1. Dies ist in der Figur 2 durch die entsprechende Stufe im Zeitpunkt t1 dargestellt.

Von dem vorgenannten Strom würde der Kondensator 39 nach dem Zeitpunkt t1 an sich von 5/6 auf die gesamte Gleichspannung Ud aufgeladen werden. Bevor dies jedoch der Fall ist, wird in einem Zeitpunkt t2 zusätzlich zu dem gesperrten Halbleiterschalter 22 auch der Halbleiterschalter 21 gesperrt sowie zusätzlich zu dem eingeschalteten Halbleiterschalter 11 auch der nächste Halbleiterschalter 12 leitend gesteuert, wobei die anderen Halbleiterschalter 13 bis 16 gesperrt und die Halbleiterschalter 17 bis 20 leitend bleiben. Dies hat zur Folge, dass ein Strom von dem Pluspol der Gleichspannung 3/6 Ud über die Halbleiterschalter 11 und 12, über den Kondensator 38 und über die Dioden 32, 31, 30 und 29 zu dem Pol der Ausgangsspannung Ua fließt.

Aufgrund des auf 2/3 der Gleichspannung Ud aufgeladenen Kondensators 38 verbleiben von der gesamten anliegenden Gleichspannung Ud nur noch -1/6 Ud derselben als Ausgangsspannung Ua in diesem Zeitpunkt t2. Dies ist in der Figur 2 durch die entsprechende weitere Stufe im Zeitpunkt t2 dargestellt.

Dieses Verfahren wird fortgesetzt, bis die Halbleiterschalter 11 bis 16 leitend gesteuert und die Halbleiterschalter 17 bis 22 gesperrt sind und damit der Pluspol der Gleichspannung 3/6 Ud über die Halbleiterschalter 11 bis 16 direkt mit dem Pol der Ausgangsspannung Ua verbunden ist. Dies bewirkt dann in der Figur 2 in einem Zeitpunkt t6 eine letzte Stufe zur gesamten Gleichspannung 3/6 Ud. Im Zeitpunkt t6 ist somit die gesamte Gleichspannung 3/6 Ud als Ausgangsspannung Ua vorhanden.

Insgesamt ist damit die Ausgangsspannung Ua von einem ersten Niveau, nämlich -Ud/2, in sechs Stufen auf ein zweites Niveau, nämlich die Gleichspannung Ud/2, angestiegen.

Danach werden die Halbleiterschalter 11 bis 16 wieder in ihren gesperrten Zustand und die Halbleiterschalter 17 bis 22 wieder in ihren leitenden Zustand gesteuert. Dies hat zur Folge, dass die Ausgangsspannung Ua stufenförmig wieder auf - Ud/2 zurückgeht. Die Stufen entsprechen dabei den in der Figur 2 gezeigten Stufen in umgekehrter Richtung.

Insgesamt ist damit ein Puls der Ausgangsspannung Ua von der Schaltung 10 erzeugt worden. Die Einschaltflanke und die Ausschaltflanke dieses Pulses sind dabei stufenförmig ausgebildet.

Die Reihenfolge der Ansteuerung der Halbleiterschalter 11 bis 22 der Figur 1 wird, soweit es die Erzeugung von positiven und negativen Flanken betrifft, in Abhängigkeit von dem Ladezustand der zugehörigen Kondensatoren 35 bis 39 ausgeführt. Diese Reihenfolge hat dabei keinen Einfluß auf die stufenförmige Form der erzeugten Spannung.

Insgesamt kann mit Hilfe der vorstehend beschriebenen Ansteuerung der Halbleiterschalter 11 bis 22 aus der eingangsseitigen Gleichspannung Ud die Ausgangsspannung Ua in der Form von Pulsen erzeugt werden, wobei die Einschalt- und Ausschaltflanken dieser Pulse jeweils stufenförmig ausgebildet sind.

Der zeitliche Abstand der einzelnen Zeitpunkte, in denen die Halbleiterschalter 11 bis 22 nacheinander umgesteuert werden, ist sehr klein. Insbesondere wird dieser zeitliche Abstand in Abhängigkeit von der Schaltzeit der verwendeten Halbleiterschalter 11 bis 22 und/oder der Resonanzfrequenz der Last, gegebenenfalls einschließlich der vorhandenen Kabel gewählt. Insbesondere kann dieser zeitliche Abstand so gewählt werden, daß die Überspannungsspitzen an der Last minimiert werden. Beispielsweise liegt der zeitliche Abstand in einem Bereich zwischen etwa 0,01 Mikrosekunden und etwa 10 Mikrosekunden. Vorzugsweise beträgt dieser Abstand, wie dies auch in der Figur 2 angegeben ist, 2 Mikrosekunden.

Aufgrund der vorstehenden Zeitabstände zwischen den einzelnen Zeitpunkten, in denen die Halbleiterschalter 11 bis 22 nacheinander umgesteuert werden, können die Kapazitäten der Kondensatoren 35 bis 39 relativ klein gewählt. Sie können dabei nach der folgenden Gleichung berechnet werden:

$$C = (I \times delta\ t) / delta\ U$$

C ist dabei die zu berechnende Kapazität, I der Ladestrom durch den jeweiligen Kondensator, delta t ist der zeitliche Abstand der einzelnen Zeitpunkte, in denen die Halbleiterschalter 11 bis 22 nacheinander umgesteuert werden, z.B. 2 Mikrosekunden, und delta U beträgt etwa 10 % der Nennspannung des zugehörigen Kondensators.

Die Reihenfolge der Ansteuerung der einzelnen in Reihe geschalteten Halbleiterschalter einer Halbgruppe sollte sich vorzugsweise danach richten, welche Kondensatoren die am meisten von ihrem Nennwert abweichende Spannung aufweisen. Auf diese Weise kann jeweils ein Stromfluss durch die Kondensatoren eingeleitet werden, der die Kondensatoren so umlädt, dass der unsymmetrischen Spannung entgegengewirkt wird.

In jeder der vorstehend beschriebenen Stufen wird nur 1/6, also etwa 17% der gesamten Gleichspannung Ud an die Ausgangsspannung Ua weitergegeben. Dies führt dazu, dass mögliche Überspannungsspitzen beispielsweise in einem nachfolgenden Elektromotor nur von diesen Stufen herrühren. Der Elektromotor muss also nicht für Überspannungsspitzen ausgelegt sein, die beim Schalten der gesamten Gleichspannung Ud auftreten würden.

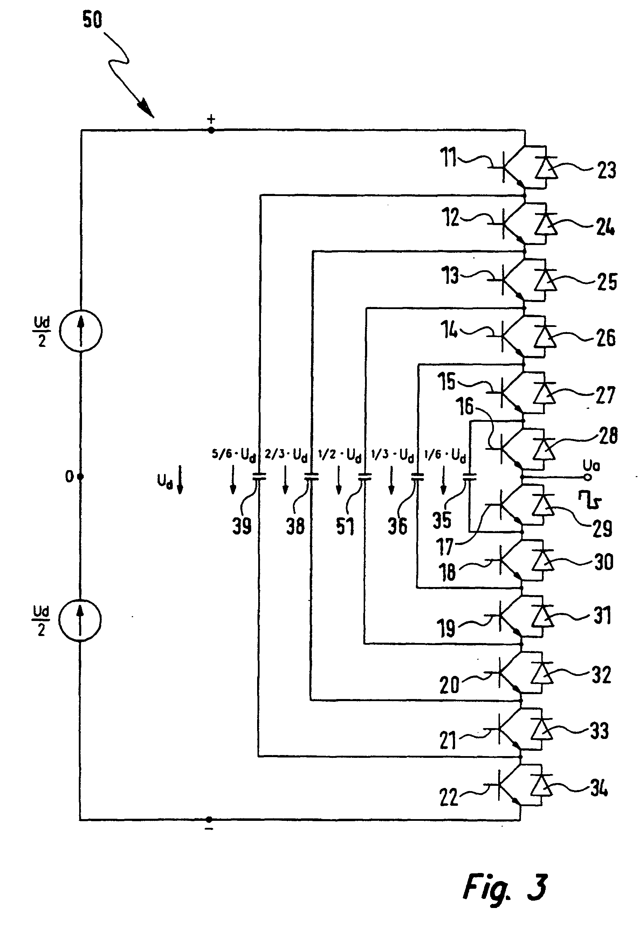

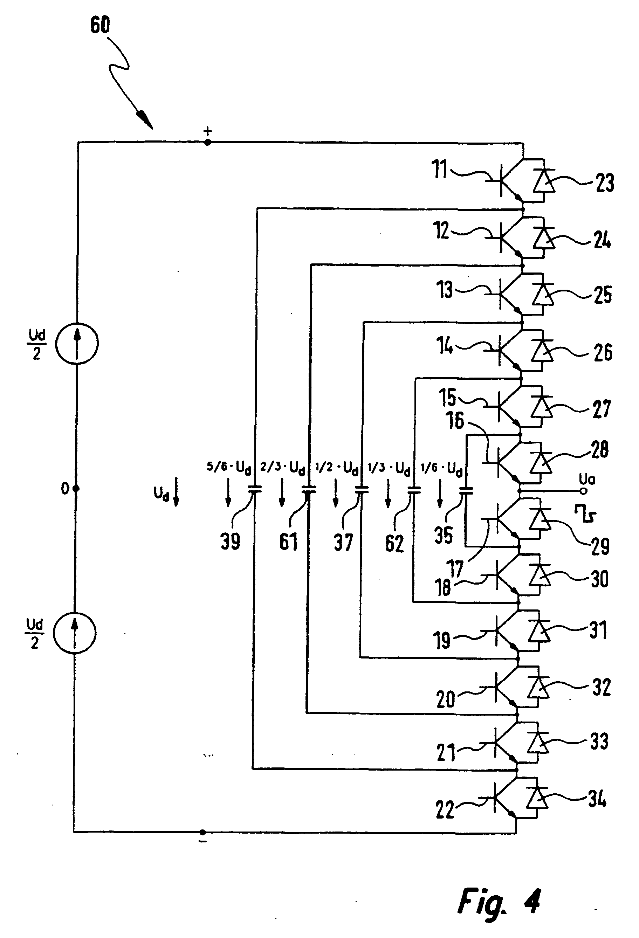

In den Figuren 3 und 4 sind elektrische Schaltungen 50 und 60 dargestellt, die weitgehend der elektrischen Schaltung 10 der Figur 1 entsprechen. Gleiche Bauteile sind deshalb mit gleichen Bezugsziffern gekennzeichnet.

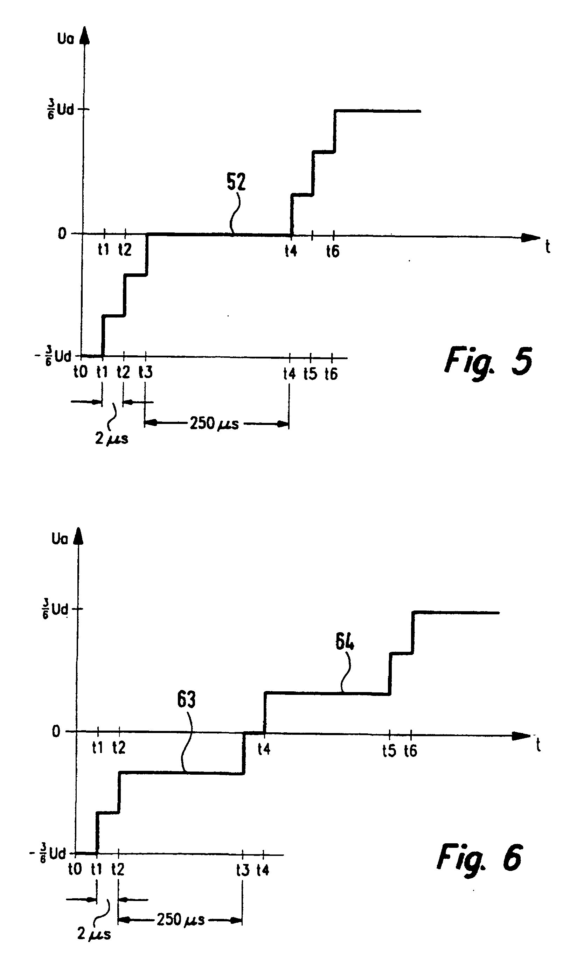

Zu der Schaltung 50 der Figur 3 gehört das Zeitdiagramm der Figur 5 und zu der Schaltung 60 der Figur 4 gehört das Zeitdiagramm der Figur 6. Die Zeitdiagramme der Figuren 5 und 6 sind dem Zeitdiagramm der Figur 2 ähnlich. Gleiche Merkmale sind deshalb mit gleichen Bezeichnungen versehen.

Bei der Schaltung 50 der Figur 3 ist als Unterschied zu der Schaltung 10 der Figur 1 ein größerer Kondensator 51 anstelle des Kondensators 37 vorgesehen. Des Weiteren ist gemäß dem Zeitdiagramm der Figur 5 zwischen den Zeitpunkten t3 und t4 ein längerer zeitlicher Abstand vorgesehen als bei dem Zeitdiagramm der Figur 2.

Der zeitliche Abstand zwischen beispielsweise den Zeitpunkten t1 und t2 beträgt bei der Figur 5 wie bisher beispielsweise 2 Mikrosekunden. Der zeitliche Abstand zwischen den Zeitpunkten t3 und t4 ist aber etwa um einen Faktor 100 größer. Dieser zeitliche Abstand liegt z.B. in einem Bereich von etwa 100 Mikrosekunden bis etwa 1000 Mikrosekunden. Vorzugsweise beträgt der zeitliche Abstand etwa 250 Mikrosekunden, wie dies auch in der Figur 5 angegeben ist.

Dies hat zur Folge, dass in der Figur 5 in den Zeitpunkten t1 und t2 die bereits aus der Figur 2 bekannten Stufen ebenfalls vorhanden sind. Zwischen den Zeitpunkten t3 und t4 ist jedoch in der Figur 5 aufgrund des größeren zeitlichen Abstands ein Absatz 52 vorhanden.

Während dieses Absatzes 52 fließt ein Strom von dem Pluspol der Gleichspannung Ud über die Halbleiterschalter 11, 12 und 13, über den Kondensator 51 und über die Dioden 31, 30 und 29 zu dem Pol der Ausgangsspannung Ua. Aufgrund des größeren zeitlichen Abstands zwischen den Zeitpunkten t3 und t4 fließt dieser Strom länger als zwischen beispielsweise den Zeitpunkten t1 und t2. Durch diesen eine längere Zeitdauer fließenden Strom wird der Kondensator 51 der Figur 3 höher belastet als der Kondensator 37 der Figur 1. Aus diesem Grund ist die Kapazität des Kondensators 51 größer gewählt als die Kapazität des Kondensators 37. Sie kann wiederum anhand der bereits angegebenen Gleichung berechnet werden, wobei sich der größere Wert der Kapazität aus dem größeren delta t. ergibt.

Die Ausgangsspannung Ua steigt damit bei der Schaltung 50 von dem ersten Niveau, nämlich -Ud/2, über drei Stufen zu einem zweiten Niveau an, nämlich dem Absatz 52, und von dort in weiteren drei Stufen zu einem dritten Niveau, nämlich zu der Gleichspannung Ud/2.

Bei Verwendung der Schaltung 50 der Figur 3 in einem Mittelspannungsstomrichter können die Halbleiterschalter 11 bis 22, beispielsweise entsprechende IGBTs, üblicherweise mit einer Schaltfrequenz von etwa 500 Hz bis etwa 1000 Hz betrieben werden. Diese Schaltfrequenzen haben bei 2-Stufen-Wechselrichtern Stromoberschwingungen in dem ausgangsseitigen Strom der Wechselspannung zur Folge, die nicht unerheblich sind.

Entsprechend der Figur 5 wird die Zwischenkreisspannung mit einem längeren Absatz 52 von Plus nach Minus geschaltet, was zu einer Reduktion der Spannungsoberschwingungen führt. Bei der Schaltung 50 der Figur 3 mit dem zugehörigen Absatz 52 entsprechend der Figur 5 weist folglich der ausgangsseitige Strom geringere Stromoberschwingungen auf als bei der Schaltung 10 der Figur 1.

Bei der Schaltung 60 der Figur 4 sind als Unterschied zu der Schaltung 10 der Figur 1 zwei größere Kondensatoren 61 und 62 anstelle der Kondensatoren 38 und 36 vorgesehen. Die Kapazität der Kondensatoren 61, 62 entspricht etwa der Kapazität des Kondensators 51 der Figur 3.

Des Weiteren ist gemäß der Figur 6 zwischen den Zeitpunkten t2 und t3 und zwischen den Zeitpunkten t4 und t5 jeweils ein längerer zeitlicher Abstand vorgesehen als bei der Figur 2. Dieser längere zeitliche Abstand entspricht etwa demjenigen der Figur 5.

Dies hat zur Folge, dass gemäß der zu der Schaltung 60 zugehörigen Figur 6 zwei Absätze 63 und 64 vorhanden sind.

Die Ausgangsspannung Ua steigt damit bei der Schaltung 60 von dem ersten Niveau, nämlich -Ud/2, über zwei Stufen zu einem zweiten Niveau an, nämlich dem Absatz 63, von dort in weiteren zwei Stufen zu einem dritten Niveau, nämlich dem Absatz 64, und von dort in weiteren zwei Stufen zu einem vierten Niveau, nämlich zu der Gleichspannung Ud/2.

Bei der Schaltung 60 der Figur 4 mit den zugehörigen Absätzen 63 und 64 entsprechend der Figur 6 weist der ausgangsseitige Strom der Wechselspannung damit noch geringere Stromoberschwingungen auf als bei der Schaltung 50 der Figur 3.

**Patentansprüche**

1. Elektrische Schaltung (10; 50; 60), insbesondere für einen Mittelspannungsstromrichter, mit mindestens vier Halbleiterschaltern (15, 16, 17, 18), die eine aus zwei Teilen bestehende Reihenschaltung bilden, die mit Polen einer Gleichspannung (Ud) verbunden ist, wobei jedem der Halbleiterschalter (15, 16, 17, 18) eine Diode (27, 28, 29, 30) gegensinnig parallelgeschaltet ist, und wobei zu den Halbleiterschaltern (15, 16, 17, 18) ein Kondensator parallelgeschaltet ist, mit einem Pol einer Ausgangsspannung (Ua), der mittig mit der Reihenschaltung verbunden ist, und der die beiden Teile der Reihenschaltung voneinander trennt, und mit einem Steuergerät zur aufeinanderfolgenden komplementären Ansteuerung der Halbleiterschalter (15, 16, 17, 18) der beiden Teile der Reihenschaltung, wobei der Kondensator (35) nur zu den beiden mittleren Halbleiterschaltern (16, 17) parallelgeschaltet ist, und wobei der zeitliche Abstand zwischen den Übergängen zweier Halbleiterschalter (15, 16; 16, 17) desselben Teils der Reihenschaltung in den jeweils leitenden Zustand zwischen etwa 0,01 Mikrosekunden und etwa 10 Mikrosekunden, vorzugsweise etwa 2 Mikrosekunden beträgt.

2. Schaltung (10; 50; 60) nach Anspruch 1, wobei der zeitliche Abstand zwischen den Übergängen zweier Halbleiterschalter (15, 16 oder 16, 17) in Abhängigkeit von der Schaltzeit eines der Halbleiterschalter (15 bis 18) und/oder der Resonanzfrequenz der Last, gegebenenfalls einschließlich der vorhandenen Kabel gewählt ist.

3. Schaltung (10; 50; 60) nach einem der Ansprüche 1 bis 3, wobei entsprechende weitere Halbleiterschalter (14, 13, 12, 11, 19, 20, 21, 22), Dioden (26, 25, 24, 23, 31, 32, 33, 34) und Kondensatoren (36, 37, 38, 39; 51; 63, 64) vorgesehen sind, wobei die Kondensatoren (36, 37, 38, 39; 51; 63, 64) immer nur zu einer geradzahligen Anzahl von mittleren Halbleiterschaltern (14, 13, 12, 11, 19, 20, 21, 22) parallelgeschaltet sind, und wobei die Halbleiterschalter (14, 13, 12, 11, 19, 20, 21, 22) der beiden Teile der Reihenschaltung durch das Steuergerät nacheinander komplementär in den leitenden Zustand steuerbar sind.

4. Schaltung (10; 50; 60) nach einem der Ansprüche 1 bis 3, wobei die Kapazität des Kondensators (35) bzw. der Kondensatoren (35 bis 39) sehr klein ist.

5. Schaltung (50; 60) nach einem der Ansprüche 1 bis 4, wobei der zeitliche Abstand zwischen den Übergängen zweier benachbarter Halbleiterschalter (13, 14; 12, 13 und 14, 15) in den jeweils leitenden Zustand groß ist, insbesondere zwischen etwa 100 Mikrosekunden und etwa 1000 Mikrosekunden, vorzugsweise etwa 250 Mikrosekunden.

6. Verfahren zum Betreiben einer elektrischen Schaltung (10; 50; 60), insbesondere für einen Mittelspannungsstromrichter, wobei die Schaltung (10; 50; 60) mit einer Mehrzahl von Halbleiterschaltern (15, 16, 17, 18) versehen ist, die eine aus zwei Teilen bestehende Reihenschaltung bilden, die mit Polen einer Gleichspannung (Ud) verbunden ist, wobei jedem der Halbleiterschalter (15, 16, 17, 18) eine Diode (27, 28, 29, 30) gegensinnig parallelgeschaltet ist, wobei zu den Halbleiterschaltern (15, 16, 17, 18) ein Kondensator parallelgeschaltet ist, wobei die Schaltung (10; 50; 60) mit einem Pol einer Ausgangsspannung (Ua) versehen ist, der mittig mit der Reihenschaltung verbunden ist, und der die beiden Teile der Reihenschaltung voneinander trennt, wobei die Halbleiterschalter (15, 16, 17, 18) der beiden Teile der Reihenschaltung nacheinander komplementär in ihren leitenden Zustand gesteuert werden, wobei der Kondensator (35) nur zu den beiden mittleren Haltleiterschaltern (16, 17) parallelgeschaltet ist, und wobei der zeitliche Abstand zwischen den Übergängen zweier Halbleiterschalter (15, 16; 16, 17) desselben Teils der Reihenschaltung in den jeweils leitenden Zustand zwischen etwa 0,01 Mikrosekunden und etwa 10 Mikrosekunden, vorzugsweise etwa 2 Mikrosekunden beträgt.

7. Verfahren nach Anspruch 6, wobei der zeitliche Abstand zwischen den Übergängen zweier Halbleiterschalter (15, 16 oder 16, 17) in Abhängigkeit von der Schaltzeit eines der Halbleiterschalter (15 bis 18) und/oder der Resonanzfrequenz der Last, gegebenenfalls einschließlich der vorhandenen Kabel gewählt ist.

8. Verfahren nach einem der Ansprüche 6 oder 7, wobei der zeitliche Abstand zwischen den Übergängen zweier benachbarter Halbleiterschalter (13, 14; 12, 13 und 14, 15) in den jeweils leitenden Zustand groß ist, insbesondere zwischen etwa 100 Mikrosekunden und etwa 1000 Mikrosekunden, vorzugsweise etwa 250 Mikrosekunden.

9. Verfahren nach einem der Ansprüche 6 bis 8, wobei die Reihenfolge der Ansteuerung der Halbleiterschalter (15 bis 18) desselben Teils der Reihenschaltung in Abhängigkeit von dem Ladezustand der zugehörigen Kondensatoren (35) ausgeführt wird.

**Claims**

1. Electrical circuit (10; 50; 60), in particular for a medium-voltage static converter, comprising: at least four semiconductor switches (15, 16, 17, 18) forming a two-part series circuit, which is connected to the terminals of a direct voltage (Ud), wherein a diode (27, 28, 29, 30) is connected in inverse-parallel with each of the semiconductor switches (15, 16, 17, 18) and wherein a capacitor is connected in parallel with the semiconductor switches (15, 16, 17, 18); an output voltage terminal (Ua), which is connected to the middle of the series circuit and separates the two parts of the series circuit from each other; and a control apparatus for driving the semiconductor switches (15, 16, 17, 18) of the two parts of the series circuit one after the other in a complementary manner, the capacitor (35) being connected in parallel with the two middle semiconductor switches (16, 17) only, and the time interval between the transitions of two semiconductor switches (15, 16; 16, 17) of the same part of the series circuit into their respective conductive states amounting to between approximately 0.01 microseconds and approximately 10 microseconds, and preferably approximately 2 microseconds.

2. Circuit (10: 50: 60) according to Claim 1, wherein the time interval between the transitions of two of the semiconductor switches (15, 16 or 16, 17) is chosen in dependence on the switching time of one of the semiconductor switches (15-18) and/or the resonance frequency of the load, including any cabling that may be present.

3. Circuit (10; 50; 60) according to any one of Claims 1 to 3, wherein corresponding further semiconductor switches (14, 13, 12, 11, 19, 20, 21, 22), diodes (26, 25, 24, 23, 31, 32, 33, 34) and capacitors (36, 37, 38, 39; 51; 63, 64) are provided, the capacitors (36, 37, 38, 39; 51; 63, 64) being connected in parallel with an even number of middle semiconductor switches (14, 13, 12, 11, 19, 20, 21, 22) only, and wherein the semiconductor switches (14, 13, 12, 11, 19, 20, 21, 22) of the two parts of the series circuit can be driven one after the other in a complementary manner into their conductive state by the control apparatus.

4. Circuit (10; 50; 60) according to any one of Claims 1 to 3, wherein the capacitance of the capacitor (35) or capacitors (35-39) is very low.

5. Circuit (50: 60) according to any one of Claims 1 to 4, wherein the time interval between the transitions of two neighbouring semiconductor switches (13, 14; 12, 13 and 14, 15) into their respective conductive states is long, in particular between approximately 100 microseconds and approximately 1000 microseconds, preferably approximately 250 microseconds.

6. Method for operating an electrical circuit (10; 50; 60), in particular for a medium-voltage static converter, the circuit (10; 50; 60) being provided with a plurality of semiconductor switches (15, 16, 17, 18) forming a two-part series circuit, which is connected to the terminals of a direct voltage (Ud), wherein a diode (27, 28, 29, 30) is connected in inverse-parallel with each of the semiconductor switches (15, 16, 17, 18); a capacitor is connected in parallel with the semiconductor switches (15, 16, 17, 18); the circuit (10; 50; 60) is provided with an output voltage terminal (Ua), which is connected to the middle of the series circuit and separates the two parts of the series circuit from each other; the semiconductor switches (15, 16, 17, 18) of the two parts of the series circuit are driven one after the other in a complementary manner into their conductive state; the capacitor (35) is connected in parallel with the two middle semiconductor switches (16, 17) only, and wherein the time interval between the transitions of two semiconductor switches (15, 16; 16, 17) of the same part of the series circuit into their respective conductive states amounts to between approximately 0.01 microseconds and approximately 10 microseconds, preferably approximately 2 microseconds.

7. Method according to Claim 6, wherein the time interval between the transitions of two of the semiconductor switches (15, 16 or 16, 17) is chosen in dependence on the switching time of one of the semiconductor switches (15-18) and/or the resonance frequency of the load, including any cabling that may be present.

8. Method according to Claim 6 or Claim 7, wherein the time interval between the transitions of two neighbouring semiconductor switches (13, 14; 12, 13 and 14, 15) into their respective conductive states is long, in particular between approximately 100 microseconds and approximately 1000 microseconds, preferably approximately 250 microseconds.

9. Method according to any one of Claims 6 to 8, wherein the order in which the semiconductor switches (15-18) of the same part of the series circuit are driven depends on the state of charge of the associated capacitors (35).

**Revendications**

1. Montage électrique (10; 50; 60) destiné notamment à un convertisseur à moyenne tension, avec au moins quatre commutateurs à semi-conducteurs (15, 16, 17, 18) formant un montage en série composé de deux parties qui est relié à des pôles d'une tension continue (Ud), une diode (27, 28, 29, 30) étant montée en antiparallèle sur chacun des commutateurs à semi-conducteurs (15, 16, 17, 19) et un condensateur étant monté en parallèle sur les commutateurs à semi-conducteurs (15, 16, 17, 18), avec un pôle d'une tension de sortie (Ua) qui est relié au point milieu du montage en série et qui sépare les deux parties du montage en série l'une de l'autre, et avec un module de commande pour l'excitation complémentaire successive des commutateurs à semi-conducteurs (15, 16, 17, 18) des deux parties du montage en série, le condensateur (35) étant monté en parallèle uniquement sur les deux commutateurs à semi-conducteurs du milieu (16, 17) et l'intervalle de temps entre les transitions de deux commutateurs à semi-conducteurs (15, 16; 16, 17) de la même partie du montage en série à leur état conducteur respectif étant compris entre 0,01 microsecondes environ et 10 microsecondes environ, de préférence égal à 2 microsecondes environ.

2. Montage (10; 50; 60) selon la revendication 1, dans lequel l'intervalle de temps entre les transitions de deux commutateurs à sémi-conducteurs (15, 16 ou 16, 17) est choisi en fonction du temps de commutation de l'un des commutateurs à semi-conducteurs (15 à 18) et/ou de la fréquence de résonance de la charge, y compris le cas échéant le câble existant.

3. Montage (10; 50; 60) selon l'une des revendications 1 à 3, dans lequel il est prévu d'autres commutateurs à semi-conducteurs (14, 13, 12, 11, 19, 20, 21, 22), d'autres diodes (26, 25, 24, 23, 31, 32, 33, 34) et d'autres condensateurs (36, 37, 38, 39; 51; 63, 64) correspondants, les condensateurs (36, 37, 38, 39; 51; 63, 64) n'étant toujours montés en parallèle que sur un nombre pair de commutateurs à semi-conducteurs médians (14, 13, 12, 11, 19, 20, 21, 22) et les commutateurs à semi-conducteurs (14, 13, 12, 11, 19, 20, 21, 22) des deux parties du montage en série pouvant être commandés successivement de manière complémentaire par le module de commande pour passer à l'état conducteur.

4. Montage (10; 50; 60) selon l'une des revendications 1 à 3, dans lequel la capacité du condensateur (35) ou des condensateurs (35 à 39) est très petite.

5. Montage (50; 60) selon l'une des revendications 1 à 4, dans lequel l'intervalle de temps entre les transitions de deux commutateurs à semi-conducteurs voisins (13, 14; 12, 13 et 14, 15) à leur état conducteur respectif est grand, notamment compris entre 100 microsecondes environ et 1000 microsecondes environ, et de préférence égal à 250 microsecondes environ.

6. Procédé pour faire fonctionner un montage électrique (10; 50; 60) destiné notamment à un convertisseur à moyenne tension, dans lequel le montage (10; 50; 60) est doté d'une pluralité de commutateurs à semi-conducteurs (15, 16, 17, 18) formant un montage en série composé de deux parties qui est relié à des pôles d'une tension continue (Ud), une diode (27, 28, 29, 30) étant montée en antiparallèle sur chacun des commutateurs à semi-conducteurs (15, 16, 17, 18), un condensateur étant monté en parallèle sur les commutateurs à semi-conducteurs (15, 16, 17, 18), dans lequel le montage (10; 50; 60) est doté d'un pôle d'une tension de sortie (Ua) qui est relié au point milieu du montage en série et qui sépare les deux parties du montage en série l'une de l'autre, dans lequel les commutateurs à semi-conducteurs (15, 16, 17, 18) des deux parties du montage en série sont commandés successivement de manière complémentaire pour passer à leur état conducteur, dans lequel le condensateur (35) n'est monté en parallèle que sur les deux commutateurs à semi-conducteurs du milieu (16, 17) et dans lequel l'intervalle de temps entre les transitions de deux commutateurs à semi-conducteurs (15, 16; 16, 17) de la même partie du montage en série à leur état conducteur respectif est compris entre 0,01 microsecondes environ et 10 microsecondes environ, de préférence égal à 2 microsecondes environ.

7. Procédé selon la revendication 6, dans lequel l'intervalle temporel entre les transitions de deux commutateurs à semi-conducteurs (15, 16 ou 16, 17) est choisi en fonction du temps de commutation de l'un des commutateurs à semi-conducteurs (15 à 18) et/ou de la fréquence de résonance de la charge, y compris le cas échéant le câble existant.

8. Procédé selon la revendication 6 ou la revendication 7, dans lequel l'intervalle temporel entre les transitions de deux commutateurs à semi-conducteurs voisins (13, 14; 12, 13 et 14, 15) à leur état conducteur respectif est grand, notamment compris entre 100 microsecondes environ et 1000 microsecondes environ, et de préférence égal à 250 microsecondes environ.

9. Procédé selon l'une des revendications 6 à 8, dans lequel la séquence d'excitation des commutateurs à semi-conducteurs (15 à 18) de la même partie du montage en série se fait en fonction de l'état de charge des condensateurs (35) correspondants.

Fig. 1

Fig. 2

*Fig. 3*

11

**Fig. 4**

**Fig. 5**

**Fig. 6**